# EUROPEAN PATENT APPLICATION

(11) **EP 4 386 116 A1**
(43) Date of publication of application: **19.06.2024**
(21) Application number: 22855776.5
(22) Date of filing: 19.07.2022
(51) Int. Cl.: C30B 29/06, H01L 21/20, H01L 29/201

(54) **NITRIDE SEMICONDUCTOR SUBSTRATE AND METHOD FOR PRODUCING SAME**

(30) Priority: 10.08.2021 JP 2021130675
(71) Applicant: Shin-Etsu Handotai Co., Ltd., Tokyo 100-0004 (JP)
(72) Inventor: HAGIMOTO, Kazunori, Annaka-shi, Gunma 379-0196 (JP); KUBONO, Ippei, Annaka-shi, Gunma 379-0196 (JP)
(74) Representative: Mooser, Sebastian Thomas
(86) International application number: PCT/JP2022/027993
(87) International publication number: WO 2023/017712

(57) **Abstract**

The present invention is a nitride semiconductor substrate comprising: a composite substrate with multiple layers stacked, a silicon oxide layer or a TEOS layer having a central flat surface and a side surface around the flat surface and stacked on the composite substrate; a single crystal silicon layer stacked on the silicon oxide layer or the TEOS layer, and a nitride semiconductor thin film deposited on the single crystal silicon layer, wherein the entire central flat surface of the silicon oxide layer or the TEOS layer is covered with the single crystal silicon layer. As a result, a nitride semiconductor substrate and a method for manufacturing the same are provided in which the mirror edge surface after epitaxial growth is free from haze, and therefore has no dust or reaction traces and fewer failures during the process.

## Description

### TECHNICAL FIELD

The present invention relates to a nitride semiconductor substrate and a method for manufacturing the same.

### BACKGROUND ART

Nitride semiconductors such as GaN and AlN can be used to fabricate high electron mobility transistors (HEMT) and high-voltage electronic devices using two-dimensional electron gas.

It is difficult to manufacture a nitride wafer in which these nitride semiconductors are grown on a substrate, and a sapphire substrate or a SiC substrate is used as the substrate. However, in order to increase the diameter and to reduce the cost of the substrate, epitaxial growth using vapor phase growth on a silicon substrate is used. The manufacturing of an epitaxially grown film by vapor phase growth on a silicon substrate allows the use of a substrate with a larger diameter than a sapphire substrate or a SiC substrate, so it is advantageous in terms of high device productivity and heat dissipation. However, stress caused by differences in lattice constants and thermal expansion coefficients tends to cause increased warpage and plastic deformation, so stress reduction is performed using growth conditions and relaxation layers.

In high-voltage electronic devices, it is necessary to deposit epitaxial layers thickly in order to improve high-voltage characteristics. Therefore, if the epitaxial layer is deposited thickly, the wafer will warp due to the difference in thermal expansion coefficient between the silicon substrate and the epitaxial layer.

Therefore, a large-diameter substrate (hereinafter referred to as a composite substrate) for growing a nitride semiconductor epitaxial film, which has a large diameter and a thermal expansion coefficient close to that of a nitride semiconductor, has been developed. The composite substrate includes: a composite substrate including a polycrystalline ceramic core, a first adhesion layer coupled throughout the polycrystalline ceramic core, a conductive layer optionally coupled throughout the first adhesion layer, a second adhesion layer coupled throughout the conductive layer or the first adhesion layer, and a barrier layer coupled throughout the second adhesion layer; a silicon oxide layer coupled to only one side of the composite substrate; and a single crystal silicon layer coupled to the silicon oxide layer (Patent Document 1).

By using this composite substrate, it is possible to produce a nitride semiconductor epitaxial growth substrate that has a large diameter, a thick epitaxial layer, and does not generate cracks. In addition, since the difference in thermal expansion coefficient from that of the nitride semiconductor is small, warpage is less likely to occur during growth or cooling of the nitride semiconductor, and warpage of the substrate after the film formation can be controlled to be small. Furthermore, since most of the composite substrate is made of ceramics, not only is the substrate itself very hard and difficult to plastically deform, but also wafer cracking, which cannot be solved with GaN/Si, does not occur.

However, when a nitride semiconductor substrate with a HEMT structure is manufactured by epitaxially growing a nitride semiconductor using a growth substrate including a silicon oxide layer coupled to only one side of such a composite substrate and a single crystal silicon layer coupled to the silicon oxide layer, haze generates on the mirror edge surface after the epitaxial growth. Reaction traces are often generated at the interface between the mirror surface and the hazy portion, which becomes a source of dust during the process. Further, residues of chemicals and the like during the process remain in the hazy portion, which may cause failure during the process.

### CITATION LIST

### PATENT LITERATURE

Patent Document 1: JP 2021-502701 A

### SUMMARY OF INVENTION

### TECHNICAL PROBLEM

The present invention has been made to solve the above problems, and an object is to provide a nitride semiconductor substrate that has no haze on the mirror edge surface after epitaxial growth, has no dust or reaction traces, and has fewer defects during the process, and a method for manufacturing the same.

### SOLUTION TO PROBLEM

In order to solve the above problems, the present invention provides, a nitride semiconductor substrate comprising:
a composite substrate with multiple layers stacked,
a silicon oxide layer or a TEOS layer having a central flat surface and a side surface around the flat surface and stacked on the composite substrate;
a single crystal silicon layer stacked on the silicon oxide layer or the TEOS layer, and
a nitride semiconductor thin film deposited on the single crystal silicon layer,
wherein the entire central flat surface of the silicon oxide layer or the TEOS layer is covered with the single crystal silicon layer.

In this way, if the nitride semiconductor substrate is such that the flat surface of the silicon oxide layer or TEOS layer is not exposed from the edge of the single crystal silicon layer, which is the growth surface of the nitride semiconductor thin film, the nitride semiconductor thin film does not grow as polycrystalline on the flat surface of the silicon oxide layer or the TEOS layer, so a nitride semiconductor substrate with no haze on the mirror edge surface, no dust or reaction traces, and fewer failures during the process can be obtained.

Further, it is preferable that the side surface of the silicon oxide layer or the TEOS layer is covered with a silicon nitride film.

Such a nitride semiconductor substrate can more reliably suppress the generation of haze.

The composite substrate preferably includes a polycrystalline ceramic core, a first adhesion layer stacked over the entire polycrystalline ceramic core, a second adhesion layer stacked over the entire first adhesion layer, and a barrier layer stacked over the entire second adhesion layer.

At this time, the composite substrate may have a conductive layer stacked over the entire first adhesion layer between the first adhesion layer and the second adhesion layer.

A nitride semiconductor substrate using such a composite substrate can be a nitride semiconductor substrate in which warpage of the substrate after film formation is suppressed.

Further, it is preferable that the conductive layer includes a polysilicon layer.

Further, it is preferable that the first adhesion layer and the second adhesion layer contain TEOS or silicon oxide, and the barrier layer contains silicon nitride.

With such a nitride semiconductor substrate, it is possible to further reduce the warpage of the substrate after the film formation, and it is also possible to form a thick nitride semiconductor thin film.

Further, it is preferable that the polycrystalline ceramic core contains aluminum nitride.

With such a nitride semiconductor substrate, the warpage of the substrate after the film formation can be further reduced.

The present invention also provides a method for manufacturing a nitride semiconductor substrate, the method comprising:
(1) a step of preparing a composite substrate with multiple layers stacked and a single crystal silicon substrate;
(2) a step of joining the single crystal silicon substrate onto the composite substrate via a silicon oxide layer or a TEOS layer;
(3) a step of forming a single crystal silicon layer by thinning the bonded single crystal silicon substrate;
(4) a step of forming an edge portion of the silicon oxide layer or the TEOS layer and the single crystal silicon layer so that the entire central flat surface of the silicon oxide layer or the TEOS layer is covered with the single crystal silicon layer;
(5) a step of growing an AlN film on the single crystal silicon layer, and
(6) a step of growing one or more selected from a GaN film, an AlGaN film, and an AlN film on the AlN film.

With such a manufacturing method, it is possible to relatively easily manufacture a nitride semiconductor substrate with no haze on the mirror edge surface, no dust generation or reaction traces, and fewer failures during the process.

Further, it is preferable that the step (4) is a chamfering step.

In this way, manufacturing can be performed without increasing the number of conventional steps.

Further, between the step (4) and the step (5), it is preferable to further include a step (4') of covering at least a side surface of the silicon oxide layer or the TEOS layer with a silicon nitride film.

In this way, exposure of the silicon oxide layer or TEOS layer can be reliably avoided.

It is preferable that the composite substrate includes a polycrystalline ceramic core, a first adhesion layer stacked over the entire polycrystalline ceramic core, a second adhesion layer stacked over the entire first adhesion layer, and a barrier layer stacked over the entire second adhesion layer.

Moreover, at this time, it is preferable that the composite substrate has a conductive layer stacked over the entire first adhesion layer between the first adhesion layer and the second adhesion layer.

With such a manufacturing method, it is possible to further reduce the warpage of the substrate after the film formation.

### ADVANTAGEOUS EFFECTS OF INVENTION

As described above, according to the present invention, it is possible to provide a nitride semiconductor substrate that has no haze on the mirror edge surface after epitaxial growth, has no dust generation or reaction traces, and has fewer failures during the process, and a method for manufacturing the same.

### BRIEF DESCRIPTION OF DRAWINGS

FIG. 1 is a schematic cross-sectional view showing an example of a film forming substrate in which a composite substrate, a silicon oxide layer, and a single crystal silicon layer are stacked in a nitride semiconductor substrate of the present invention;
FIG. 2 is a schematic cross-sectional view explaining in detail the silicon oxide layer in the nitride semiconductor substrate of the present invention;
FIG. 3 is a schematic cross-sectional view showing an example of a film forming substrate in which a composite substrate, in which a silicon nitride film is formed on the side surface of a silicon oxide layer, a silicon oxide layer, and a single crystal silicon layer are stacked in the nitride semiconductor substrate of the present invention;
FIG. 4 is a schematic cross-sectional view showing an example of a film forming substrate in which a composite substrate, a silicon oxide layer, and a single crystal silicon layer are stacked in a conventional nitride semiconductor substrate;
FIG. 5 is a schematic view showing an example of an MOCVD apparatus that can be used in the method for manufacturing a nitride semiconductor substrate of the present invention;
FIG. 6 is a schematic view showing an example of a film forming substrate of a nitride semiconductor substrate of the present invention;
FIG. 7 is an explanatory view of an example of the method for manufacturing a nitride semiconductor substrate of the present invention;
FIG. 8 is a cross-sectional view of a conventional nitride semiconductor substrate in which a poly layer is grown at the edge of the substrate; and
FIG. 9 is an enlarged view of the boundary between the single crystal layer and the poly layer in FIG. 8.

### DESCRIPTION OF EMBODIMENTS

As described above, when a nitride semiconductor substrate with a HEMT structure is manufactured by epitaxially growing a nitride semiconductor using a film forming substrate including a silicon oxide layer stacked to only one side of such a composite substrate and a single crystal silicon layer stacked to the silicon oxide layer, haze generates on the mirror edge surface after the epitaxial growth. Reaction traces are often generated at the interface between the mirror surface and the hazy portion, which becomes a source of dust during the process.

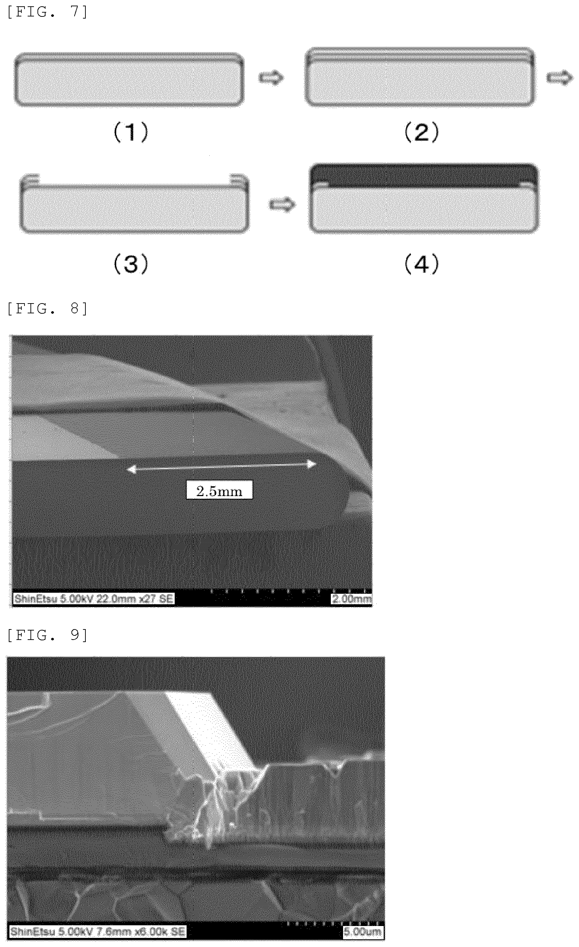

When the inventors of the present invention conducted a cross-sectional SEM observation of the mirror surface area and the hazy area, it was found that the nitride semiconductor thin film had grown as a single crystal in the mirror area, while poly had grown in the hazy area (FIG. 8). It was also found that the mirror portion grew on the single crystal silicon layer, but the hazy portion grew on the silicon oxide layer. FIG. 9 shows the interface between the single crystal and the poly-grown portion. Further, residues of chemicals and the like during the process remain in the poly portion, which may cause failure during the process.

Then, it has been found that a substrate having no haze on the edge of the substrate can be achieved by a nitride semiconductor substrate which includes a nitride semiconductor thin film grown on a film forming substrate in which a single crystal silicon layer is joined via a silicon oxide layer onto a composite substrate in which a plurality of layers is stacked, wherein the flat surface of the silicon oxide layer is not exposed from the edge portion of the single crystal silicon layer, which is the growth surface of the nitride semiconductor thin film, and the present invention has been completed.

That is, the present invention is a nitride semiconductor substrate comprising: a composite substrate with multiple layers stacked, a silicon oxide layer or a TEOS layer having a central flat surface and a side surface around the flat surface and stacked on the composite substrate; a single crystal silicon layer stacked on the silicon oxide layer or the TEOS layer, and a nitride semiconductor thin film deposited on the single crystal silicon layer, wherein the entire central flat surface of the silicon oxide layer or the TEOS layer is covered with the single crystal silicon layer.

The present invention is also a method for manufacturing a nitride semiconductor substrate, the method comprising: (1) a step of preparing a composite substrate with multiple layers stacked and a single crystal silicon substrate; (2) a step of joining the single crystal silicon substrate onto the composite substrate via a silicon oxide layer or a TEOS layer; (3) a step of forming a single crystal silicon layer by thinning the bonded single crystal silicon substrate; (4) a step of forming an edge portion of the silicon oxide layer or the TEOS layer and the single crystal silicon layer so that the entire central flat surface of the silicon oxide layer or the TEOS layer is covered with the single crystal silicon layer; (5) a step of growing an AlN film on the single crystal silicon layer, and (6) a step of growing one or more selected from a GaN film, an AlGaN film, and an AlN film on the AlN film.

Hereinafter, the present invention will be explained in detail, but the present invention is not limited thereto.

### (First embodiment)

The nitride semiconductor substrate of the present invention includes: a film forming substrate which includes a composite substrate, a bonding layer made of a silicon oxide layer (SiO₂ layer) or a TEOS (tetraethyl orthosilicate) layer, and a single crystal silicon layer; and a nitride semiconductor thin film formed on the film forming substrate, and the entire flat surface of the bonding layer is covered with the single crystal silicon layer. Hereinafter, the case where the bonding layer is a silicon oxide layer will be described as an example in this specification, but the same can be applied to the case where the bonding layer is a TEOS layer.

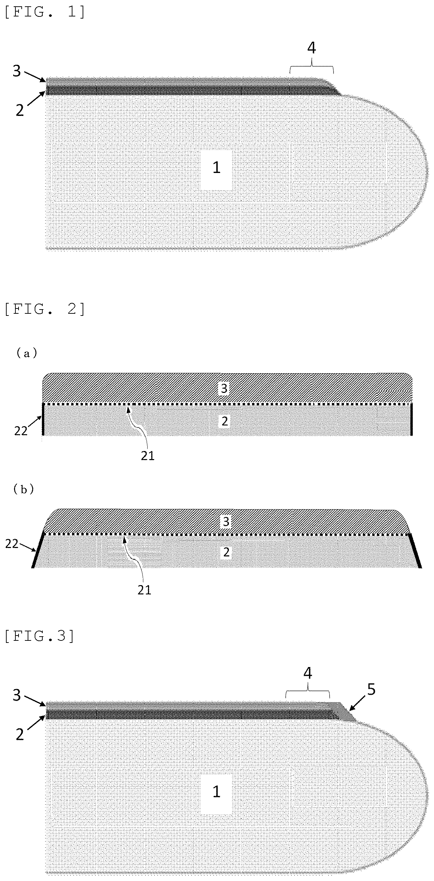

FIG. 1 shows an example of a film forming substrate including a composite substrate, a silicon oxide layer, and a single crystal silicon layer in the nitride semiconductor substrate of the present invention. In this film forming substrate, a single crystal silicon layer 3 is stacked on a composite substrate 1 via a silicon oxide layer 2 interposed therebetween. Here, the difference from the prior art is that the entire flat surface of the silicon oxide layer 2 in FIG. 1 is covered with the single crystal silicon layer 3. That is, the silicon oxide layer is not exposed at the edge portion 4 of the flat surface of the silicon oxide layer. That is, the entire central flat surface of the silicon oxide layer 2 is covered with the single crystal silicon layer 3.

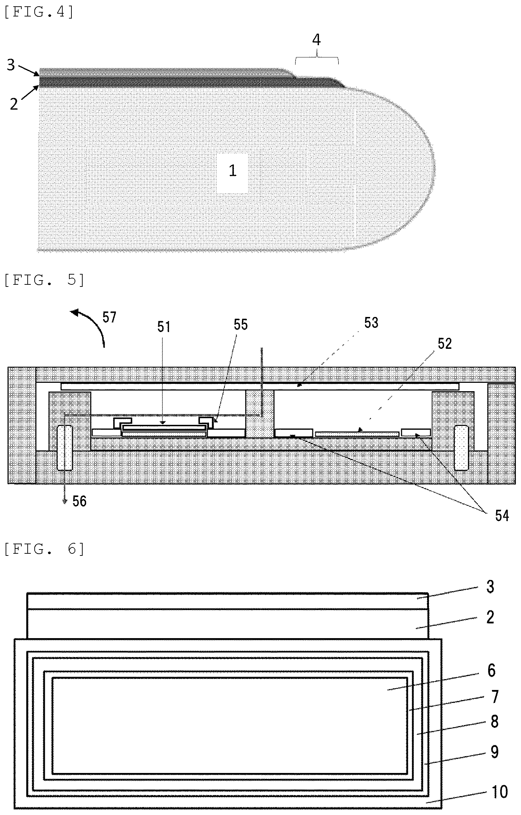

As shown in FIG. 4, in a conventional nitride semiconductor substrate, the edge portion 4 of the flat surface of the silicon oxide layer 2 is not covered with the single crystal silicon layer 3. Therefore, when a nitride semiconductor thin film is grown on a film forming substrate, a poly layer of the nitride semiconductor thin film ends up growing on the exposed silicon oxide layer 2 at the edge 4 of the flat surface. In contrast, in the present invention, since the silicon oxide layer 2 is not exposed at the edge portion 4 of the flat surface, the poly layer of the nitride semiconductor thin film does not grow on the silicon oxide layer 2.

Here, the structure of the silicon oxide layer in the present invention will be explained in more detail using FIG. 2. As shown in (a) and (b) in FIG. 2, in the nitride semiconductor substrate of the present invention, the silicon oxide layer 2 has a central flat surface 21 (the surface indicated by the dotted line) and a side surface 22 (the surface indicated by the thick line) around the flat surface. In the present invention, the entire flat surface 21 is covered with the single crystal silicon layer 3. On the other hand, the side surface 22 around the flat surface 21 is covered with or is not covered with the single crystal silicon layer 3, but it is preferable that manufacturing is easier if the side surface is not covered with the single crystal silicon layer 3. Moreover, the side surface 22 may be perpendicular to the flat surface 21 as shown in (a), or the side surface 22 may be inclined as shown in (b). Furthermore, although the side surface 22 is drawn as a straight line (plane) in the drawing, the side surface 22 may be curved. Moreover, the side surface 22 may be a chamfered surface.

In the present invention, the nitride semiconductor thin film formed on the film forming substrate may include an AlN film, and a GaN film, an AlGaN film, or both formed thereon. For example, epitaxial growth of an AlN film, an AlGaN film, and a GaN film can be performed on a film forming substrate using a rotation-revolution type MOCVD reactor as shown in FIG. 5.

For example, as shown in FIG. 6, the film forming substrate can be composed of: a composite substrate which includes a polycrystalline ceramic core 6, a first adhesion layer 7 stacked over the entire polycrystalline ceramic core, a conductive layer 8 stacked over the entire first adhesion layer 7, a second adhesion layer 9 stacked over the entire conductive layer 8, and a barrier layer 10 stacked over the entire second adhesion layer 9; a silicon oxide layer 2 stacked on only one surface of the composite substrate; and a single crystal silicon layer 3 stacked on the silicon oxide layer 2.

Here, the polycrystalline ceramic core 6 may include aluminum nitride, which is preferably sintered at a high temperature of, for example, 1800 °C with a sintering aid, and preferably has a thickness of about 300 to 1150 um. Basically, the ceramic core is often formed in a thickness that meets the SEMI standard for single crystal silicon substrates.

The first adhesion layer 7 and the second adhesion layer 9 can be a layer containing tetraethyl orthosilicate (TEOS) or silicon oxide (SiO₂), and are preferably deposited by, for example, an LPCVD process or a CVD process, and preferably have a thickness of 100 nm.

The conductive layer 8 may include a polysilicon layer and is deposited, for example, by an LPCVD process, and preferably has a thickness of about 300 nm. The layer is a layer for imparting conductivity, and can be doped with boron (B), phosphorus (P), etc., for example. Moreover, the conductive layer 8 is not deposited in some cases.

The barrier layer 10 may include silicon nitride and is deposited, for example, by LPCVD process, and preferably has a thickness of 400 nm to 500 nm. The layer is a layer for preventing the elements present in the ceramic core, such as yttrium, yttrium oxide, oxygen, metal impurities, and other trace elements, from diffusing or outgassing into the environment of the semiconductor processing chamber during the high temperature epitaxial growth process.

The silicon oxide layer 2 is deposited by, for example, LPCVD process, and preferably has a thickness of about 1.5 um. The single crystal silicon layer 3 preferably has a thickness of 300 to 500 nm. This layer is used as a growth surface for epitaxial growth of a nitride semiconductor such as AlN or GaN.

The thickness of each layer is not limited to the above mentioned values, and not all layers are necessarily present, but the film forming substrate in the present invention has at least a single crystal silicon layer, a silicon oxide layer or a TEOS layer, and a composite substrate in which multiple layers are stacked.

The nitride semiconductor substrate of the first embodiment of the present invention can be manufactured, for example, as follows by the method for manufacturing a nitride semiconductor substrate of the present invention.

First, a composite substrate and a single crystal silicon substrate as described above are prepared (step (1)). The single crystal silicon substrate may have an oxide film (silicon oxide layer) attached thereto.

Next, a single crystal silicon substrate is joined onto the composite substrate via the silicon oxide layer (step (2)). The silicon oxide layer is deposited on the composite substrate by, for example, LPCVD process, and preferably has a thickness of about 1.5 um. Alternatively, the silicon oxide layer may be a combination of a silicon oxide layer deposited on a composite substrate and a silicon oxide layer attached to a single crystal silicon substrate. The single crystal silicon substrate can be stacked and joined to the silicon oxide layer using, for example, a layer transfer process.

Next, the joined single crystal silicon substrate is thinned to form a single crystal silicon layer (step (3)). It is preferable that the single crystal silicon layer has a thickness of 300 to 500 nm. The method for thinning the single crystal silicon layer is not particularly limited, and conventional methods can be applied. For example, after joining a composite substrate and a single crystal silicon substrate via a silicon oxide layer, a thin film can be formed by grinding, polishing, or etching the surface of the single crystal silicon substrate. Alternatively, a so-called ion implantation separation method may be used in which an ion-implanted layer is formed in advance on a single crystal silicon substrate and the ion-implanted layer is separated after joining.

Next, the edge of the silicon oxide layer and the single crystal silicon layer are formed so that the entire central flat surface of the silicon oxide layer is covered with the single crystal silicon layer (step (4)). The step (4) can be a step of chamfering the outer periphery of the single crystal silicon. At this time, for example, as shown in FIG. 1, the chamfering is performed so that the flat portion of the silicon oxide layer is not exposed.

Next, a nitride semiconductor thin film is formed on the single crystal silicon layer. This step includes, for example, a step of growing an AlN film on the single crystal silicon layer (step (5)), and a step of growing one or more selected from a GaN film, an AlGaN film, and an AlN film on the AlN film (step (6)).

FIG. 5 shows a schematic view of an example of an MOCVD apparatus that can be used in the method for manufacturing a nitride semiconductor substrate of the present invention. The MOCVD apparatus includes a satellite 52 having a pocket on which a film forming substrates 51 is placed, a quartz ceiling 53, a quartz 54, and a ring-shaped member 55 placed so as to cover the inside from the edge of the film forming substrate 51. 56 is the direction of carrier gas flow, and 57 is the direction of opening the lid.

The film forming substrate can be placed in a wafer pocket called a satellite, for example, as shown in FIG. 5. During epitaxial growth, it is possible to use trimethylaluminum (TMAl) as an Al source, TMGa as a Ga source, and NH₃ as an N source without limitation thereto. Further, the carrier gas can be N₂ and/or H₂, and the process temperature is preferably about 900 to 1200°C, for example.

At this time, a film forming substrate is placed on the satellite, and then the lid is closed and epitaxial growth is performed. At this time, as the epitaxial layer, for example, an AlN film and an AlGaN film can be formed and then a GaN film can be epitaxially grown in order from the substrate side toward the growth direction. The structure of the epitaxial layer is not limited to this, and there are cases in which the AlGaN film is not formed, or in which an AlN film is further formed after the AlGaN film is formed.

### (Second embodiment)

As shown in FIG. 3, the nitride semiconductor substrate of the present invention may have a film forming substrate including a composite substrate 1, a silicon oxide layer 2, and a single crystal silicon layer 3, wherein the side surface of the silicon oxide layer 2 is covered with a silicon nitride film 5. With such a nitride semiconductor substrate, it is possible to more reliably prevent a poly layer of a nitride semiconductor thin film from growing on the edge of the film forming substrate. Note that the silicon nitride film 5 may cover only the side surface of the silicon oxide layer 2, may cover the side surface of the silicon oxide layer 2 and the side surface of the single crystal silicon layer 3, or may further cover up to the edge portion of the epitaxial growth surface of the single crystal silicon layer 3.

In the second embodiment, a portion of the silicon oxide layer is exposed by chamfering (that is, the side surface of the silicon oxide layer is exposed), and the exposed silicon oxide layer is covered with a silicon nitride film (step (4')). Specifically, as shown in FIG. 7, a CVD-SiN film is deposited on the entire surface of the firstly chamfered wafer ((1) in FIG. 7). Thereafter, in a photolithography process, the exposed silicon oxide layer is protected with a resist so as to cover it ((2) in FIG. 7), and then the active layer portion is exposed. This wafer is dry etched using a dry etching apparatus to remove the SiN film in the active layer portion ((3) in FIG. 7). After that, the resist as the protective film is removed and cleaned. After that, epitaxial growth is performed in the same manner as in the first embodiment ((4) in FIG. 7).

### EXAMPLE

Hereinafter, the present invention will be specifically explained using Examples and Comparative Example, but the present invention is not limited thereto.

### (Example 1)

A 300 um polycrystalline ceramic core was covered with a 100 nm TEOS layer, the TEOS layer was covered with a 300 nm polysilicon layer, the polysilicon was covered with a 100 nm TEOS layer, the TEOS layer was covered with a 400 nm silicon nitride layer (barrier layer), and a silicon oxide film was attached thereto. And a single crystal silicon substrate with an oxide film attached thereto was bonded thereto, and the surface of the single crystal silicon substrate was polished to be thinned (400 nm). Next, when chamfering the edge portion, the single crystal silicon layer was not excessively grinded by chamfering so that the flat surface of the silicon oxide layer was not exposed on the wafer surface as shown in FIG. 1. Thereafter, a HEMT structure (3 nm of GaN / 25 nm of AlGaN / 5000 nm of GaN / 200 nm of graded AlGaN / 150 nm of AlN / n-Si) was epitaxially grown.

The yield according to the manufacturing method of Example 1 was improved by 4% compared to the Comparative Example described below.

### (Example 2)

As shown in Figure 7, after joining a single crystal silicon layer, the edge was chamfered to expose the side surfaces of the silicon oxide film, and a CVD-SiN film was deposited on the entire surface of the wafer, followed by a photolithography process to cover and protect the exposed oxide film and expose the active layer portion. The wafer was dry-etched using a dry etching apparatus to remove the SiN film on the active layer portion and the resist as the protective film was removed and cleaned. Through the above steps, a nitride semiconductor substrate in which the side surfaces of the silicon oxide layer were covered with a silicon nitride film was manufactured.

The yield according to the manufacturing method of Example 2 was improved by 6% compared to the Comparative Example described below.

### (Comparative example)

A nitride semiconductor substrate was manufactured under the same conditions as in Example 1, except that a portion of the flat surface of the silicon oxide film was exposed on the wafer surface as shown in FIG. 4. As a result, the yield was lower than in Examples 1 and 2.

Note that the present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A nitride semiconductor substrate comprising:
a composite substrate with multiple layers stacked,
a silicon oxide layer or a TEOS layer having a central flat surface and a side surface around the flat surface and stacked on the composite substrate;
a single crystal silicon layer stacked on the silicon oxide layer or the TEOS layer, and
a nitride semiconductor thin film deposited on the single crystal silicon layer,
wherein the entire central flat surface of the silicon oxide layer or the TEOS layer is covered with the single crystal silicon layer.

2. The nitride semiconductor substrate according to claim 1, wherein the side surface of the silicon oxide layer or the TEOS layer is covered with a silicon nitride film.

3. The nitride semiconductor substrate according to claim 1 or 2, wherein the composite substrate includes a polycrystalline ceramic core, a first adhesion layer stacked over the entire polycrystalline ceramic core, a second adhesion layer stacked over the entire first adhesion layer, and a barrier layer stacked over the entire second adhesion layer.

4. The nitride semiconductor substrate according to claim 3, wherein the composite substrate has a conductive layer stacked over the entire first adhesion layer between the first adhesion layer and the second adhesion layer.

5. The nitride semiconductor substrate according to claim 4, wherein the conductive layer includes a polysilicon layer.

6. The nitride semiconductor substrate according to any one of claims 3 to 5, wherein the first adhesion layer and the second adhesion layer contain TEOS or silicon oxide, and the barrier layer contains silicon nitride.

7. The nitride semiconductor substrate according to any one of claims 3 to 6, wherein the polycrystalline ceramic core contains aluminum nitride.

8. A method for manufacturing a nitride semiconductor substrate, the method comprising:
(1) a step of preparing a composite substrate with multiple layers stacked and a single crystal silicon substrate;
(2) a step of joining the single crystal silicon substrate onto the composite substrate via a silicon oxide layer or a TEOS layer;
(3) a step of forming a single crystal silicon layer by thinning the bonded single crystal silicon substrate;
(4) a step of forming an edge portion of the silicon oxide layer or the TEOS layer and the single crystal silicon layer so that the entire central flat surface of the silicon oxide layer or the TEOS layer is covered with the single crystal silicon layer;
(5) a step of growing an AlN film on the single crystal silicon layer, and
(6) a step of growing one or more selected from a GaN film, an AlGaN film, and an AlN film on the AlN film.

9. The method for manufacturing a nitride semiconductor substrate according to claim 8, wherein the step (4) is a chamfering step.

10. The method for manufacturing a nitride semiconductor substrate according to claim 8 or 9, wherein the method further includes a step (4') of covering at least a side surface of the silicon oxide layer or the TEOS layer with a silicon nitride film between the step (4) and the step (5).

11. The method for manufacturing a nitride semiconductor substrate according to any one of claims 8 to 10, wherein the composite substrate includes a polycrystalline ceramic core, a first adhesion layer stacked over the entire polycrystalline ceramic core, a second adhesion layer stacked over the entire first adhesion layer, and a barrier layer stacked over the entire second adhesion layer.

12. The method for manufacturing a nitride semiconductor substrate according to claim 11, wherein the composite substrate has a conductive layer stacked over the entire first adhesion layer between the first adhesion layer and the second adhesion layer.
